# EUROPEAN PATENT APPLICATION

(11) **EP 2 905 061 A1**
(43) Date of publication of application: **12.08.2015**
(21) Application number: 15152456.8
(22) Date of filing: 26.01.2015
(51) Int. Cl.: B01D 53/06, B01D 53/26, F25D 21/04

(54) **Dehumidification configuration**

(30) Priority: 05.02.2014 JP 2014020007
(71) Applicant: Mitsubishi Electric Corporation, Chiyoda-ku Tokyo 100-8310 (JP)
(72) Inventor: Kijima, Takumi, Tokyo 1008310 (JP)
(74) Representative: Pfenning, Meinig & Partner GbR

(57) **Abstract**

A dehumidification configuration 100 includes a dehumidification area 10 as an area for removing moisture contained in air, and a reproduction area 20 as an area for separating the moisture having been removed in the dehumidification area 10, inside a casing 9. The dehumidification configuration 100 further includes, inside the casing 9, a non-dehumidification area 30 as an area in which there is placed a main part of a cooling unit 4 for cooling a heat 5 generating member which is a to-be-cooled part placed in the dehumidification area 10. The dehumidification area 10 has a configuration sealed from the reproduction area 20 and the non-dehumidification area 30.

## Description

### BACKGROUND OF THE INVENTION

### Field of the Invention

The present invention relates to dehumidification configurations for preventing condensation in electronic apparatuses or electric apparatuses.

### Description of the Background Art

Electronic apparatuses or electric apparatuses (hereinafter, referred to as "apparatuses") are required to be cooled for coping with heat generation from internal members therein and may be cooled to temperatures equal to or lower than the ambient temperature by cooling means including refrigerant circuits and the like, in some cases. Such cooling means induces spots in which the temperature is equal to or lower than the dew point, in the casing, thereby inducing condensation therein. Such condensation induces operational malfunctions and reliability degradations. Therefore, as one of countermeasures against condensation, there have been methods for dehumidifying inside of a casing.

There have been suggested a plurality of techniques for purposefully inducing condensations in air within a casing for dehumidification and, further, storing it as water resulted from the dehumidification in a receiving plate or a tank, thereby dehumidifying the air within the casing. However, these methods involve complicacy of the configurations of such receiving plates or tanks including holding configurations, and the like. Further, these methods require users to perform disposal of the water resulted from dehumidification at regular time intervals. Therefore, these methods are not suitable for apparatuses required to be maintenance-free. Therefore, there have been suggested various techniques which necessitate no disposal of water resulted from dehumidification, out of techniques for preventing condensations.

For example, as examples of applications to laser-device holding boxes and laser systems, there have been systems for causing decomposition and permeation of moisture in air, using an electrolyte-film dehumidification unit. Further, there have been systems provided with a porous-member dehumidification unit and a dehumidification unit including an air-inflow inner door and an air-outflow outer door, thereby enabling absorption and discharge of moisture in air (refer to Japanese Patent Application Laid-Open No. 2003-295241, for example).

Further, as examples of applications to projectors, for example, there have been systems including a dehumidification device, a ventilation device and a damper which are provided in a substantially-sealed duct, in order to discharge moisture in a casing to the outside (refer to Japanese Patent Application Laid-Open No. 2009-222998, for example).

Further, there have been systems including dampers with a circular shape partitioned at 90-degrees intervals for separately providing areas for absorbing moisture in air for dehumidification, and areas for discharging moisture for humidification, wherein these dampers are made rotatable for enabling changeover of air-flow paths (refer to Publication of Japanese Patent No. 4772099, for example). This is a technique suggested mainly for humidification, but can be also applied to techniques for dehumidification of the inside of a casing, by placing this system in such a way as to transfer humidified air to the outside of the casing while transferring dehumidified air to the inside of the casing.

Further, as methods for dehumidification or humidify control in a certain area such as a vegetable room in a refrigerator, there have been methods adapted to employ moisture absorption means and to provide separated air-flow paths for performing absorption and discharge of moisture (refer to Publication of Japanese Patent No. 4619379 and Publication of Japanese Patent No. 5143210, for example).

However, with the technique described in Japanese Patent Application Laid-Open No. 2003-295241, the electrolyte-film dehumidification unit has lower dehumidifying speeds. Therefore, this technique is suitable for applications for maintaining the humidity in residential spaces and the like, but this technique necessitates longer time periods for applications for lowering the humidity within casings to a predetermined humidity, which has induced the problem of increases of time periods required for activating the apparatuses. Further, in the example where the porous-member dehumidification unit is employed, there is a need for operational members such as the air-inflow inner door and the air-outflow outer door and, also, there is a need for control means for controlling the opening and closing of the inner door and the outer door.

Further, the techniques described in Japanese Patent Application Laid-Open No. 2009-222998 and Publication of Japanese Patent No. 4772099 necessitate means for opening and closing the suction port and the discharge port for external air and, also, necessitate a member such as a damper as air-flow-path changeover means, which has induced the problem of complicacy of the configuration. Further, there is only a single air suction port, as a source of absorption and discharge of moisture. Therefore, when air containing moisture is discharged using the ventilation means, external air with a higher humidity than that of the inside of the casing is sucked therethrough into the casing. This has induced the problem of poor dehumidification efficiency.

Further, the techniques described in Publication of Japanese Patent No. 4619379 and Publication of Japanese Patent No. 5143210 are techniques for separately performing dehumidification and humidification within the casing in the refrigerator for adjusting the respective humidity, wherein both the dehumidification portion and the humidification portion are structured within the single casing, which makes it impossible to reduce the total amount of moisture contained in air within the casing.

### SUMMARY OF THE INVENTION

It is an object of the present invention to provide a technique for realizing a dehumidification configuration with high dehumidification performance in a simple structure.

According to the present invention, there is provided a dehumidification configuration which includes a dehumidification area as an area for removing moisture contained in air, and a reproduction area as an area for separating the moisture having been removed in the dehumidification area, inside a casing. The dehumidification configuration further includes, inside the casing, a non-dehumidification area as an area in which there is placed a main part of a cooling unit for cooling a to-be-cooled part placed in the dehumidification area. The dehumidification area has a configuration sealed from the reproduction area and the non-dehumidification area.

Since the dehumidification area has a configuration sealed from the reproduction area and the non-dehumidification area, it is possible to prevent air other than leaked air from entering and exiting thereinto and therefrom. Further, since the dehumidification configuration includes the non-dehumidification area in which the main part of the cooling unit is placed, inside the casing, the main part of the cooling unit is not placed in the dehumidification area, which allows the dehumidification area to have a minimum volume. This can shorten the time period required to reach a target dew point, thereby realizing a dehumidification configuration with higher dehumidification performance.

Further, since the dehumidification area has the configuration sealed from the reproduction area and the non-dehumidification area, there is no need for providing an air-suction door, an air-discharging door and the like thereto and, thus, there is no need for providing control means for controlling them. Further, there is no need for providing a damper and the like as air-flow path changeover means. This can realize a dehumidification configuration with high dehumidification performance in a simple structure.

These and other objects, features, aspects and advantages of the present invention will become more apparent from the following detailed description of the present invention when taken in conjunction with the accompanying drawings.

### BRIEF DESCRIPTION OF THE DRAWINGS

FIG. 1 is a schematic view of an apparatus including a dehumidification configuration according to a first preferred embodiment;
FIGS. 2A and 2B are each a perspective view of the apparatus including the dehumidification configuration according to the first preferred embodiment;
FIG. 3 is a side view of the apparatus including the dehumidification configuration according to the first preferred embodiment;
FIG. 4 is a perspective view of a dehumidification unit in the dehumidification configuration according to the first preferred embodiment;
FIG. 5 is a graph illustrating the relative humidity and the dew point within a dehumidification area, in the apparatus including the dehumidification configuration according to the first preferred embodiment;
FIG. 6 is a perspective view of a dehumidification unit in a dehumidification configuration according to a second preferred embodiment;
FIG. 7 is a side view of an apparatus including a dehumidification configuration according to a third preferred embodiment; and
FIG. 8 is a perspective view of a dehumidification unit in the dehumidification configuration according to the third preferred embodiment.

### DESCRIPTION OF THE PREFERRED EMBODIMENTS

### <First Preferred Embodiment>

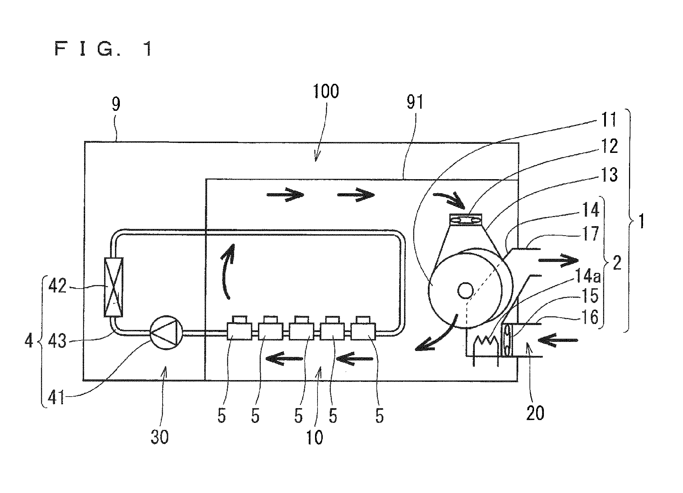

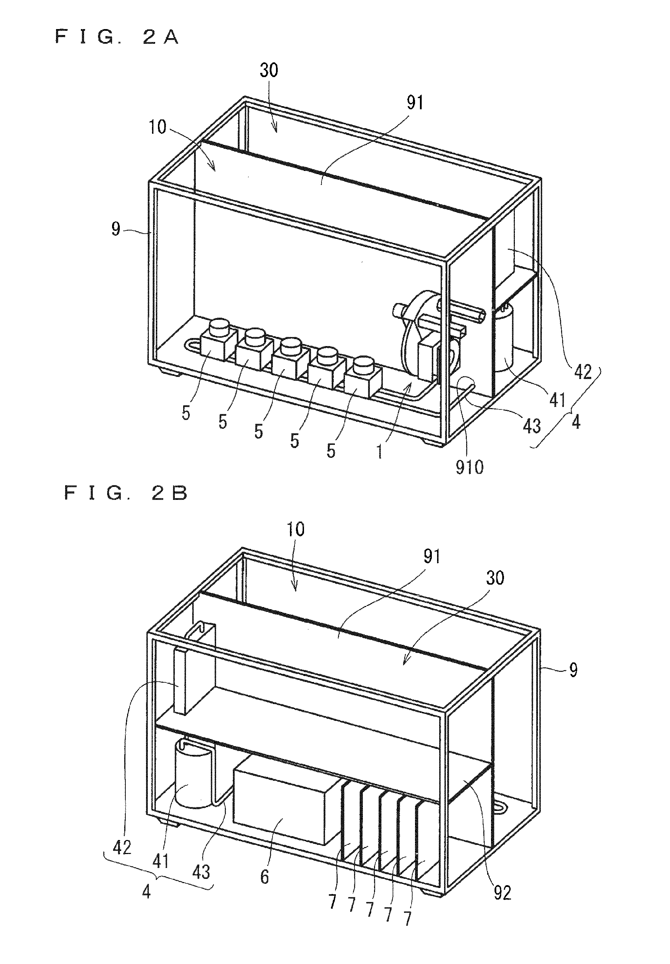

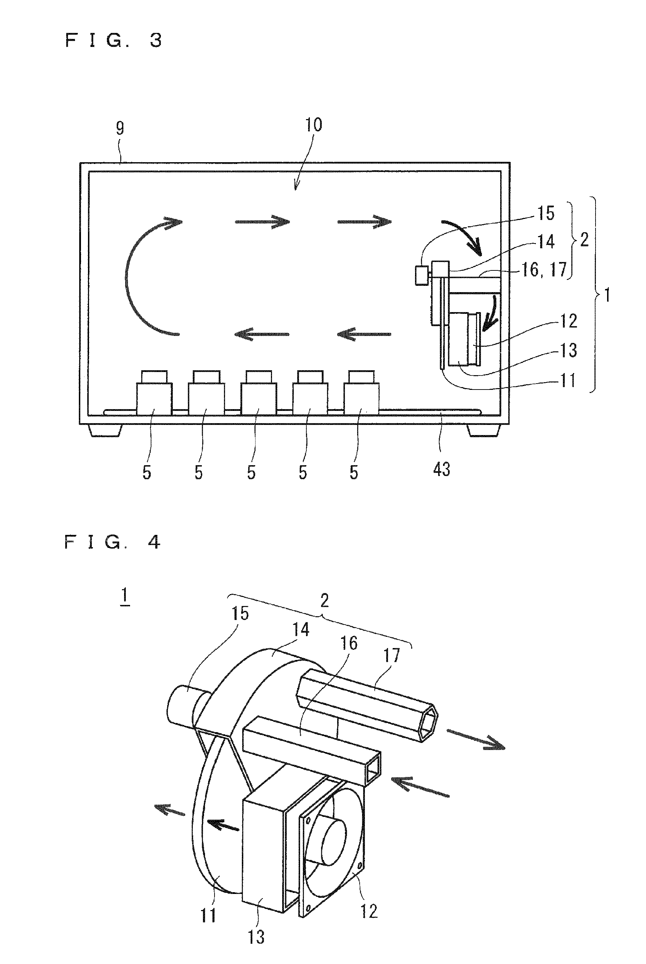

Hereinafter, a first preferred embodiment of the present invention will be described, with reference to the drawings. Fig. 1 is a schematic view of an apparatus including a dehumidification configuration 100 according to the first preferred embodiment. Fig. 2A is a perspective view of the apparatus including the dehumidification configuration 100, and Fig. 2B is a perspective view illustrating the apparatus including the dehumidification configuration 100 as viewed from a different direction. Fig. 3 is a side view of the apparatus including the dehumidification configuration 100, and Fig. 4 is a perspective view of a dehumidification unit 1 in the dehumidification configuration 100. Further, the apparatus is an electronic apparatus or an electric apparatus.

There will be described an example where the dehumidification configuration 100 according to the first preferred embodiment is applied to the apparatus. As illustrated in Figs. 1 to 3, the apparatus includes a casing 9, a cooling unit 4, heat generating members 5 (to-be-cooled parts), a power supply part 6, and a substrate part 7 constituted by a plurality of substrates, and the dehumidification configuration 100. In this case, the casing 9 is illustrated in a state where an outer panel thereof is removed for convenience of description, and the same applies to the other figures.

Inside the casing 9, there are placed a first partition plate 91 and a second partition plate 92, and the inside of the casing 9 is partitioned into three areas by the first partition plate 91 which partitions the inside of the casing 9 into left and right sides, and by the second partition plate 92 which partitions one of the spaces resulted from the partitioning by the first partition plate 91 into upper and lower sides. The three areas is a dehumidification area 10, a reproduction area 20 and a non-dehumidification area 30, and the dehumidification area 10 is formed in the other space resulted from the partitioning by the first partition plate 91. The non-dehumidification area 30 is formed in the upper and lower sides of the one space resulted from the partitioning by the first partition plate 91. Here, the reproduction area 20 will be described later.

The cooling unit 4 is cooling means for cooling the heat generating members 5 and includes a compressor 41, a condenser 42, and a refrigerant circuit constituted by a copper pipe 43 and the like. A portion of the copper pipe 43, the compressor 41 and the condenser 42, which form a main part of the cooling unit 4, are placed in the non-dehumidification area 30, while the heat generating members 5 and the remaining portion of the copper pipe 43 are placed in the dehumidification area 10. The heat generating members 5 are placed in a state of being in contact with the remaining portion of the copper pipe 43 which is placed in the dehumidification area 10 and are cooled to a predetermined temperature by the refrigerant flowing through the copper pipe 43. Further, the power supply part 6 and the substrate part 7 are also placed in the non-dehumidification area 30.

Next, the dehumidification configuration 100 will be described. As illustrated in Fig. 1, the dehumidification configuration 100 includes the dehumidification area 10, the reproduction area 20, the non-dehumidification area 30, and the dehumidification unit 1. The dehumidification area 10 is an area for removing moisture contained in the air. The reproduction area 20 is an area for separating the moisture having been removed in the dehumidification area 10. The non-dehumidification area 30 is an area which is not for dehumidification and is an area in which the main part of the cooling unit 4 is placed as described above.

As illustrated in Figs. 2A, 3 and 4, the dehumidification unit 1 is placed near the outer panel within the casing 9. The dehumidification unit 1 includes an absorption part 11, a dehumidification fan 12, a dehumidification duct 13, and a reproduction part 2. The absorption part 11 is constituted by a disk-shaped rotational member formed from a porous base member which has been coated, surface-treated or impregnated with an absorbent which is formed from a zeolite, a silica gel, an activated carbon, an activated alumina or the like. The absorption part 11 is structured to be rotatable about a center axis at a speed of about a half rotation per minute by being driven by a motor (not illustrated). Further, the absorption part 11, which is placed to extend from the dehumidification area 10 to the reproduction area 20, will be described in detail, later.

As illustrated in Fig. 3, the dehumidification duct 13 is placed in the outer panel side of the casing 9 with respect to the absorption part 11, and the dehumidification fan 12 is placed in the outer panel side of the casing 9 with respect to the dehumidification duct 13. Namely, the dehumidification duct 13 is placed between the dehumidification fan 12 and the absorption part 11. The dehumidification fan 12 is adapted to cause air within the dehumidification area 10 to flow through the absorption part 11 via the dehumidification duct 13 and, further, is adapted to circulate air throughout the entire dehumidification area 10. Further, in the figure, arrows indicate the directions of air flows, and the same applies to the other figures.

Next, the reproduction part 2 will be described. As illustrated in Figs. 1, 3 and 4, the reproduction part 2 includes a reproduction duct 14, a heater 14a, a reproduction fan 15, a suction duct 16, and a discharge duct 17. In this case, the area surrounded by the reproduction part 2 is the reproduction area 20.

The reproduction duct 14 is a duct for flowing, therethrougn, air flows caused by the air sucked through the suction duct 16 for separating moisture from the absorption part 11. The reproduction duct 14 is constituted by a hollow member which interiorly contains the blade parts of the reproduction fan 15 and the heater 14a as heating means. The reproduction duct 14 houses a portion of the absorption part 11. In other words, a portion of the absorption part 11 is placed in the reproduction area 20, while the remaining portion of the absorption part 11 is placed in the dehumidification area 10. The absorption part 11 is partially housed in the reproduction duct 14 with a predetermined gap interposed therebetween and, therefore, can be rotated about its center axis.

As illustrated in Fig. 4, the suction duct 16 is a duct for sucking air outside the casing 9. The suction duct 16 is coupled, at its one end, to the reproduction duct 14, near the reproduction fan 15 (more specifically, in the opposite side from the reproduction fan 15 with respect to the reproduction duct 14). The suction duct 16 is coupled, at its other end, to an opening (not illustrated) which is formed in the outer panel of the casing 9. Namely, the suction duct 16 is communicated, at its other end, with the outside of the casing 9, so that air outside the casing 9 is sucked through the suction duct 16.

The discharge duct 17 is a duct for discharging the separated moisture, to the outside of the casing 9. The discharge duct 17 is coupled, at its one end, to the reproduction duct 14, near the heater 14a. The discharge duct 17 is coupled, at its other end, to an opening (not illustrated) which is formed in the outer panel of the casing 9. Namely, the discharge duct 17 is communicated, at its other end, with the outside of the casing 9, so that the separated moisture is discharged to the outside of the casing 9 through the discharge duct 17.

As illustrated in Fig. 4, the dehumidification fan 12 is placed in the same side as that of the suction duct 16 and the discharge duct 17 with respect to the absorption part 11. Air flows for absorption with the dehumidification fan 12 in the absorption part 11 are directed in the opposite direction from that of air flows for discharge with the reproduction fan 15.

Next, the dehumidification configuration 100 will be described with respect to operations thereof. Air in the dehumidification area 10 is flowed through the surface of the absorption part 11 by the dehumidification fan 12, and the absorption part 11 absorbs moisture contained in the air, thereby dehumidifying the air in the dehumidification area 10. On the other hand, the portion of the absorption part 11 which is positioned in the reproduction area 20 is heated by the heater 14a, thereby causing the absorbed moisture to be separated therefrom. At the same time, the reproduction fan 15 sucks air outside the casing 9 through the suction duct 16 and causes air flows to flow through the reproduction duct 14. Thus, the moisture separated from the absorption part 11 is discharged to the outside of the casing 9 through the discharge duct 17.

The absorption part 11 is rotated by being driven by the motor, and the portion of the absorption part 11 which is positioned in the dehumidification area 10 is gradually moved to the reproduction area 20. At the same time, the portion of the absorption part 11 which is positioned in the reproduction area 20 is gradually moved to the dehumidification area 10. This enables continuously performing the absorption of moisture by the absorption part 11 and the discharge of absorbed moisture therefrom. Particularly, the moisture absorbed by the absorption part 11 can be directly discharged to the outside of the casing 9 from the reproduction area 20. Therefore, the portion of the absorption part 11 which is positioned in the dehumidification area 10 is always kept in a state of being capable of absorbing moisture.

The air having passed through the absorption part 11 to be dehumidified thereby proceeds to the side opposite from the dehumidification unit 1 (the left sides in the paper planes of Figs. 1 and 3) within the dehumidification area 10 and, from here, the air proceeds, again, to the dehumidification fan 12 in the dehumidification unit 1 and, then, is sucked by the dehumidification fan 12 and flows through the absorption part 11, as indicated by arrows in Figs. 1 and 3. Namely, this is a structure which necessitates no damper for changing over the movement and the direction of air, wherein dehumidified air is circulated within the dehumidification area 10. Eventually, the air in the dehumidification area 10 is dehumidified to the full extent of the moisture absorbing ability of the absorption part 11, which equalizes the humidity in the dehumidification area 10.

In this case, the dehumidification area 10 is structured to have a configuration sealed from the reproduction area 20 and the non-dehumidification area 30. In other words, the air which is sucked and discharged into and from the reproduction area 20 is prevented from being introduced into the dehumidification area 10, so that the air in the dehumidification area 10 is prevented from entering and exiting into and from the other areas. Further, since the non-dehumidification area 30 is provided, it is possible to minimize the volume of the dehumidification area 10, which enables dehumidification with higher efficiency. Further, the sealed configuration of the dehumidification area 10 also includes configurations having fine interstices, as well as completely-sealed configurations.

In the aforementioned manner, the dew point in the dehumidification area 10 can be lowered to be equal to or lower than a cooling-target temperature for the cooling unit 4. Generally, the apparatus is controlled, such that running of the cooling unit 4 is started at this time point. This enables continuously running the entire apparatus, without inducing condensation, even when the apparatus is cooled to temperatures equal to or lower than the ambient temperature around the apparatus.

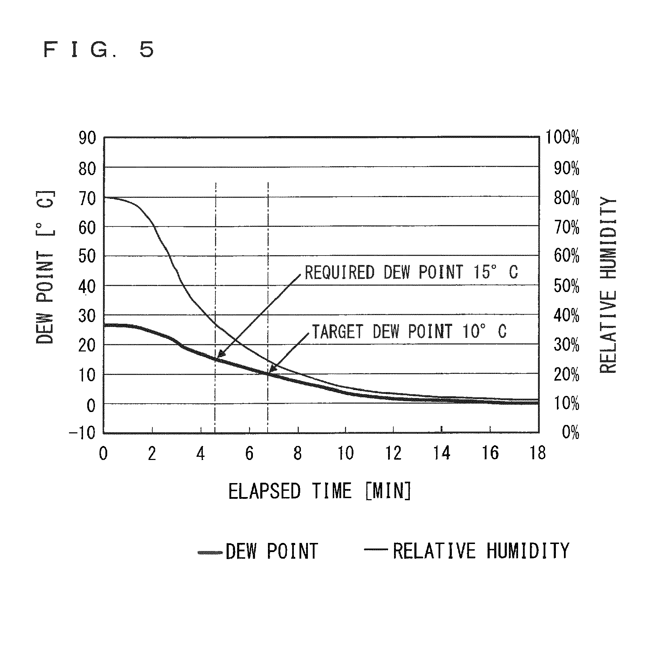

Next, there will be described actually-measured data representing the relative humidity and the dew point in the dehumidification area 10, in cases where the dehumidification unit 1 was run, in the apparatus including the dehumidification configuration 100. Fig. 5 is a graph illustrating the relative humidity and the dew point in the dehumidification area 10 in the apparatus including the dehumidification configuration 100.

As illustrated in Fig. 5, the inventors of the present application implemented the actual measurements by setting the set cooling temperature for the cooling unit 4 at 17.5±2.5°C and by setting the target performance dew point at 10° C, under an environment of 30°C and 85 %RH. In this case, the dehumidification area 10 had a sealed configuration with a volume of about 300 L (liters). After the start of running of the dehumidification unit 1, a required dew point of 15°C or less was reached in a little less than 5 minutes, and the target dew point was reached in a little less than 7 minutes and, thereafter, the dew-point equilibrium was reached at -1°C. Namely, in the case of this apparatus, by running only the dehumidification unit 1 at first at the time of activation, and, after the elapse of 5 minutes, starting running of the cooling unit 4, it is possible to continuously run the entire apparatus without inducing condensation. This time period of 5 minutes is sufficiently shorter than those in conventional techniques.

However, it is difficult to completely seal the dehumidification area 10 in such a manner that there is no air entering and exiting thereinto and therefrom. More specifically, it is difficult to completely close the fine interstices in the outer panel of the casing 9, the wirings (not illustrated), an outlet/inlet port 910 (see Fig. 2A) of the copper pipe 43, and the like. Thus, external air intrudes into the casing 9, although the amount of the external air is small. Generally, the external air has a higher humidity than that of the dehumidification area 10 and, therefore, the dehumidification area 10 tends to have a higher humidity than when it is completely sealed. In this case, within the dehumidification area 10, the humidity is stabilized at the point where the humidity is balanced with the moisture absorbing ability of the absorption part 11, depending on the degree of the sealing of the dehumidification area 10 and the humidity of the external air.

In this case, it is possible to improve the degree of the sealing of the dehumidification area 10 by applying, thereto, sealing members such as O rings or packing materials. However, it has been observed that the aforementioned balance can be maintained to provide a predetermined lower-humidity state, even without using such sealing members. In other words, according to the present invention, it is possible to provide an effect of realizing a configuration capable of preventing condensation, with an inexpensive structure, without using additional members such as O-rings or packing materials. In cases where higher dehumidification performance is required, it is possible to take measures such as sealing members, in consideration of the permissible manufacturing cost and the permissible number of members.

Further, the inventor of the present application implemented simulations regarding the dehumidification area 10, by providing an opening with a size of about 15000 mm² at an upper portion of the casing 9, under the same environmental condition of 30°C and 85 %RH, in a state where the degree of sealing was lowered on purpose, for example. After the start of running, the required dew point of 15°C was reached in about 5 minutes, further, the target dew point of 10°C was reached in a little less than 8 minutes and, finally, the dew-point equilibrium was reached at 1.7°C, although longer time periods than those of the data of Fig. 5 were taken. Namely, by detecting that a set dew point or less has been reached and, thereafter, by starting running of the cooling unit 4, it is possible to run the apparatus without inducing the problem of condensation, even with the casing with a lower degree of sealing.

As described above, in the dehumidification configuration 100 according to the first preferred embodiment, the dehumidification area 10 has a configuration sealed from the reproduction area 20 and the non-dehumidification area 30, which prevents air other than leaked air from entering and exiting thereinto and therefrom. Further, the dehumidification configuration includes the non-dehumidification area 30 in which the main part of the cooling unit 4 is placed, inside the casing 9 and, therefore, the main part of the cooling unit 4 is not placed in the dehumidification area 10, which allows the dehumidification area 10 to have a minimum volume. This can shorten the time period required to reach the target dew point, thereby realizing a dehumidification configuration with higher dehumidification performance.

Further, since it is possible to shorten the time period required to reach the target dew point, it is possible to reduce the energy consumption.

Further, since the dehumidification area 10 is adapted to prevent air other than leaked air from entering and exiting thereinto and therefrom and, also, is adapted to have a minimum volume, it is possible to lower the dehumidification ability for maintaining the dew point temperature, thereby enabling reduction of the size and the cost of the apparatus and enabling electric-power saving. Since the apparatus can be reduced in size, it is possible to reduce the volume of the packaging of the product.

Further, since the dehumidification area 10 has a configuration sealed from the reproduction area 20 and the non-dehumidification area 30, there is no need for providing an air-suction door, an air-discharging door and the like thereto and, thus, there is no need for providing control means for controlling them. Further, there is no need for providing a damper and the like as air-flow path changeover means. This can realize a dehumidification configuration with high dehumidification performance in a simple structure.

Further, since the dehumidification configuration 100 includes the absorption part 11 which is placed to extend from the dehumidification area 10 to the reproduction area 20, and absorbs moisture contained in the air in the dehumidification area 10 and separates the moisture in the reproduction area 20, it is possible to perform removal and reproduction of moisture contained in the air, with higher efficiency, using the absorption part 11.

The reproduction area 20 includes the suction duct 16 for sucking air outside the casing 9, the reproduction duct 14 in which a portion of the absorption part 11 is placed, and for flowing, therethrough, air flows caused by the air sucked through the suction duct 16 and for separating moisture from the absorption part 11, and the discharge duct 17 for discharging the separated moisture to the outside of the casing 9. Accordingly, there is no need for providing a member for storing water resulted from the dehumidification, such as a receiving plate or a tank, thereby preventing users from being bothered by disposal of the water resulted from the dehumidification.

The suction duct 16 and the discharge duct 17 are coupled, at their one ends, to the reproduction duct 14, and the suction duct 16 and the discharge duct 17 are communicated, at their other ends, with the outside of the casing 9. Accordingly, the suction duct 16 and the discharge duct 17 can be integrally formed with the reproduction duct 14 interposed therebetween, which allows the reproduction area 20 to have a minimum volume. This enables reduction of the size and the cost of the apparatus.

### <Second Preferred Embodiment>

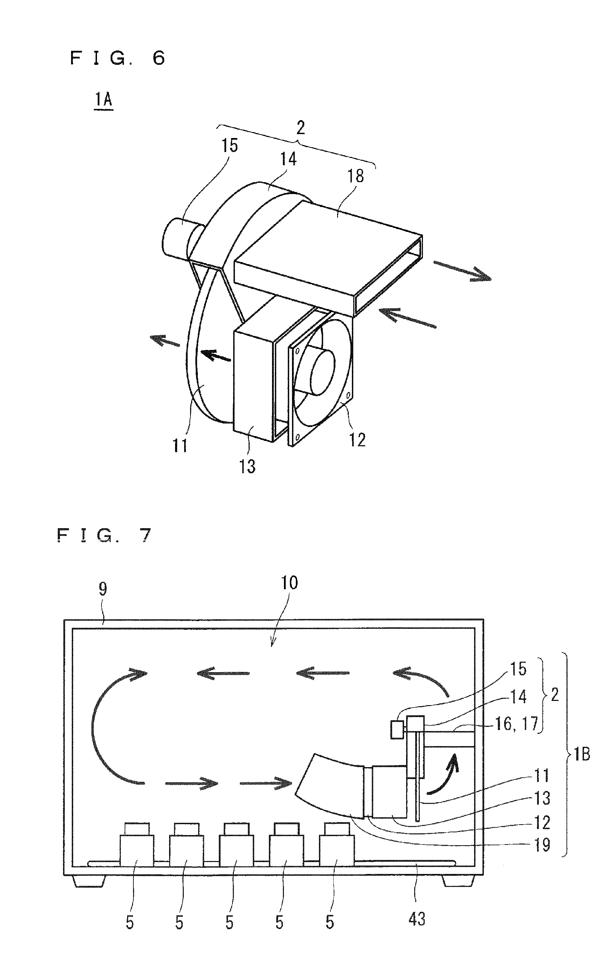

Next, there will be described a dehumidification configuration 100 according to a second preferred embodiment. Fig. 6 is a perspective view of a dehumidification unit 1A in the dehumidification configuration 100 according to the second preferred embodiment. Further, in the second preferred embodiment, the same components as those described in the first preferred embodiment are designated by the same reference characters and the description thereof will be omitted.

In the first preferred embodiment, the suction duct 16 and the discharge duct 17 are constituted by two members. On the other hand, in the second preferred embodiment of the present invention, a suction duct and a discharge duct are constituted by a suction/discharge duct 18 which is a single integrally-formed member.

The suction/discharge duct 18 is coupled, at its one end, to a reproduction duct 14 and, further, is coupled, at its other end, to an opening of an outer panel of a casing 9. Air in a reproduction area 20 acts in the direction of discharge through a reproduction fan 15, which necessarily induces suction operations within the suction/discharge duct 18, thereby causing the suction/discharge duct 18 to perform both the functions of sucking air and discharging air. In any of the cases, sucked air or discharged air is prevented from intruding into the dehumidification area 10, which prevents the air in the dehumidification area 10 from entering and exiting into and from the other areas.

As described above, in the dehumidification configuration 100 according to the second preferred embodiment, the suction duct and the discharge duct are constituted by the suction/discharge duct 18 which is a single integrally-formed member, which can provide the same effects as the effects provided in the first preferred embodiment and, also, can reduce the number of the members in the ducts. This can improve the disassembling easiness of the product and, also, can improve the transportation easiness thereof.

### <Third Preferred Embodiment>

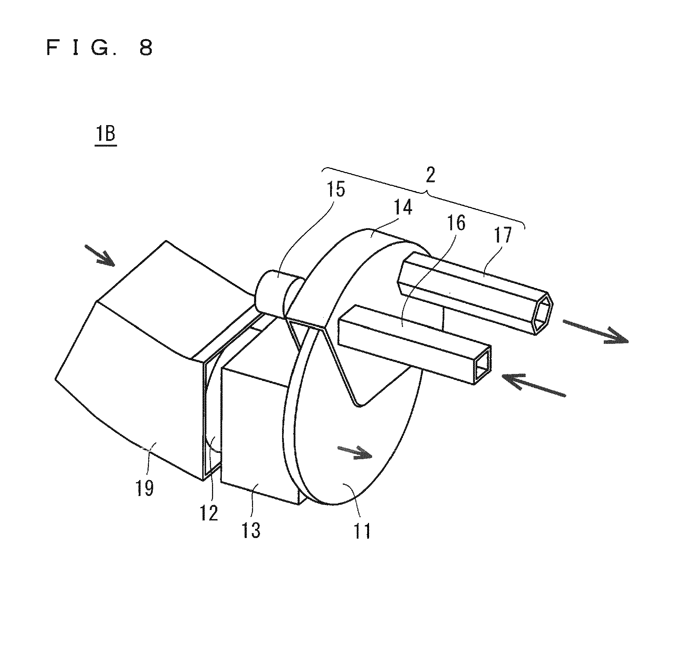

Next, a dehumidification configuration 100 according to a third preferred embodiment will be described. Fig. 7 is a side view of an apparatus including the dehumidification configuration 100 according to the third preferred embodiment, and Fig. 8 is a perspective view of a dehumidification unit 1B in the dehumidification configuration 100 according to the third embodiment. Further, in the third preferred embodiment, the same components as those described in the first and second preferred embodiments are designated by the same reference characters and the description thereof will be omitted.

Further, in the first and second preferred embodiments, air flows for absorption with the dehumidification fan 12 in the absorption part 11 are directed in the opposite direction from that of air flows for discharge with the reproduction fan 15. However, these air flows can be directed in the same direction. In order to direct these air flows in the same direction, as illustrated in Figs. 7 and 8, a dehumidification fan 12 can be placed in a left side in the paper plane with respect to the absorption part 11, which can cause the directions of air flows for absorption and discharge to be the same direction. In general, the dehumidification performance can be made higher, in cases where these air flows are directed in the opposite directions. However, the present invention is not restricted by the directions of air flows for absorption and discharge. Further, in order to facilitate circulations of the dehumidified air, it is also possible to provide a duct around the dehumidification fan 12.

As illustrated in Figs. 7 and 8, the dehumidification fan 12 is placed in the opposite side from that in Fig. 4 with respect to the absorption part 11 (in the opposite side from the suction duct 16 and the discharge duct 17 with respect to the absorption part 11), and a circulation duct 19 is placed around the dehumidification fan 12 (in the opposite side from the dehumidification duct 13 with respect to the dehumidification fan 12). In the present preferred embodiment, similarly, it is also possible to take measures such as sealing members, in consideration of the required dehumidification performance, the permissible number of members and the permissible manufacturing cost.

As described above, in the dehumidification configuration 100 according to the third preferred embodiment, air flows for absorption with the dehumidification fan 12 in the absorption part 11 are directed in the same direction as that of air flows for discharge with the reproduction fan 15. In this case, similarly, it is possible to provide the same effects as the effects provided in the first preferred embodiment and, therefore, it is possible to employ various types of structures in the dehumidification configuration 100.

While the invention has been shown and described in detail, the foregoing description is in all aspects illustrative and not restrictive. It is therefore understood that numerous modifications and variations can be devised without departing from the scope of the invention.

## Claims

1. A dehumidification configuration comprising a dehumidification area (10) as an area for removing moisture contained in air, and a reproduction area (20) as an area for separating the moisture having been removed in said dehumidification area (10), inside a casing (9), the dehumidification configuration further comprising:
a non-dehumidification area (30) as an area in which there is placed a main part of a cooling unit (4) for cooling a to-be-cooled part placed in said dehumidification area (10), inside said casing (9),
wherein
said dehumidification area (10) has a configuration sealed from said reproduction area (20) and said non-dehumidification area (30).

2. The dehumidification configuration according to claim 1, further comprising an absorption part (11) which is placed to extend from said dehumidification area (10) to said reproduction area (20), and absorbs moisture contained in air in said dehumidification area (10) and separates the moisture in said reproduction area (20).

3. The dehumidification configuration according to claim 2, wherein
said reproduction area (20) includes:
a suction duct (16) for sucking air outside said casing (9),
a reproduction duct (14) in which a portion of said absorption part (11) is placed, and for flowing, therethrough, an air flow caused by the air sucked through said suction duct (16) and for separating moisture from said absorption part (11), and
a discharge duct (17) for discharging the reproduced moisture to outside of said casing (9).

4. The dehumidification configuration according to claim 3, wherein
said suction duct (16) and said discharge duct (17) are coupled, at their one ends, to said reproduction duct (14), and said suction duct (16) and said discharge duct (17) are communicated, at their other ends, with the outside of said casing (9).

5. The dehumidification configuration according to claim 3, wherein
said suction duct (16) and said discharge duct (17) is a single integrally-formed member.
